(19) **Europäisches Patentamt / European Patent Office / Office européen des brevets**

(11) **EP 3 503 173 B1**

(12) **FASCICULE DE BREVET EUROPEEN**

(45) Date de publication et mention
de la délivrance du brevet:
**08.06.2022 Bulletin 2022/23**

(21) Numéro de dépôt: **18213093.0**

(22) Date de dépôt: **17.12.2018**

(51) Classification Internationale des Brevets (IPC):
**H01L 21/762** *(2006.01)*

(52) Classification Coopérative des Brevets (CPC):
**H01L 21/76254**

(54) **PROCEDE DE TRANSFERT D'UNE COUCHE UTILE**

ÜBERTRAGUNGSVERFAHREN EINER NUTZSCHICHT

USEFUL FILM TRANSFER METHOD

(84) Etats contractants désignés:
**AL AT BE BG CH CY CZ DE DK EE ES FI FR GB
GR HR HU IE IS IT LI LT LU LV MC MK MT NL NO
PL PT RO RS SE SI SK SM TR**

(30) Priorité: **22.12.2017 FR 1762969**

(43) Date de publication de la demande:
**26.06.2019 Bulletin 2019/26**

(73) Titulaire: **Commissariat à l'Energie Atomique et
aux Energies
Alternatives
75015 Paris (FR)**

(72) Inventeurs:
- **MORICEAU, Hubert
  38120 SAINT-EGREVE (FR)**
- **MORALES, Christophe
  38220 SAINT PIERRE DE MESAGE (FR)**

(74) Mandataire: **INNOV-GROUP
310, avenue Berthelot
69372 Lyon Cedex 08 (FR)**

(56) Documents cités:
**US-B1- 6 403 450**

- **LISOVSKII ET AL: "Effect of UV annealing of radiation damage in SiO"2 films", APPLIED SURFACE SCI, ELSEVIER, AMSTERDAM, NL, vol. 86, no. 1-4, 1 février 1995 (1995-02-01), pages 299-302, XP005278387, ISSN: 0169-4332, DOI: 10.1016/0169-4332(94)00394-7**
- **OLIVIER DEBIEU ET AL: "Effect of the Nd content on the structural and photoluminescence properties of silicon-rich silicon dioxide thin films", NANOSCALE RESEARCH LETTERS, vol. 6, no. 1, 1 janvier 2011 (2011-01-01) , page 161, XP055498724, ISSN: 1556-276X, DOI: 10.1186/1556-276X-6-161**

**EP 3 503 173 B1**

**Description**

**Domaine technique**

L'invention se rapporte au domaine technique du transfert d'une couche utile sur un substrat support par la technologie Smart Cut™.

L'invention trouve notamment son application dans la fabrication de substrats de type silicium sur isolant SOI (« *Silicon-On-Insulator* » en langue anglaise), mais aussi dans le transfert de films de matériaux III-V, ou encore dans le transfert d'une couche protégeant un oxyde conducteur (destiné à former une électrode).

**Etat de la technique antérieure**

Un procédé de transfert d'une couche utile sur un substrat support, connu de l'état de la technique, comporte les étapes successives :

ao) prévoir un substrat donneur comprenant une première surface recouverte d'une couche d'oxyde, la couche d'oxyde présentant une surface libre ;

bo) implanter des espèces gazeuses dans le substrat donneur, à travers la couche d'oxyde, de manière à former une zone de fragilisation, les espèces gazeuses comprenant des atomes d'hydrogène ionisé ; la couche utile étant délimitée par la zone de fragilisation et par la première surface du substrat donneur ;

$c_0$) assembler le substrat donneur au substrat support par une adhésion directe avec la surface libre de la couche d'oxyde ;

$d_0$) fracturer le substrat donneur suivant la zone de fragilisation de manière à exposer la couche utile, par exemple par l'application d'un traitement thermique ;

$e_0$) appliquer un traitement thermique à l'assemblage obtenu à l'issue de l'étape $d_0$), à une température supérieure à 900°C.

Un exemple d'un tel procédé est décrit dans le document US6403450 B1.

L'étape $b_0$) d'implantation s'accompagne classiquement d'une modification de la nature de la couche d'oxyde, en particulier au voisinage de la surface libre (plus particulièrement sur quelques nanomètres sous la surface libre), ce qui se traduit notamment par une augmentation de la vitesse d'attaque de l'oxyde dans cette zone d'un facteur supérieur à 2. Un tel procédé de l'état de la technique permet, grâce au traitement thermique de l'étape $e_0$), de corriger ce problème.

La publication de Lisovski I.P., Litovchenko V.G. et Lozinskii V.B, "Effect of UV annealing of radiation damage in SiO2 films", Applied Surface Science 86, 1995, pp. 299-302, constate que la structure de $SiO_2$ qui a été modifiée par bombardement ionique peut être restaurée par un éclairage UV d'intensité plutôt faible.

Toutefois, un tel procédé de l'état de la technique n'est pas entièrement satisfaisant dans la mesure où le traitement thermique de l'étape $e_0$) s'effectue à haute température, avec comme inconvénients :

- un impact potentiel des différences de coefficients de dilatation thermique (CTE) entre les matériaux du substrat donneur, de la couche d'oxyde, et du substrat support ;

- une dégradation potentielle d'un matériau de l'assemblage (par exemple, certains matériaux III-V possèdent généralement une température limite de dégradation inférieure à 900°C) ;

- une dégradation potentielle du substrat support lorsque celui-ci est fonctionnalisé avec la présence de niveaux métalliques ne supportant pas des températures supérieures à 500°C.

**Exposé de l'invention**

L'invention vise à remédier en tout ou partie aux inconvénients précités. A cet effet, l'invention a pour objet un procédé de transfert d'une couche utile sur un substrat support, comportant les étapes successives :

a) prévoir un substrat donneur comprenant une première surface recouverte d'une couche d'oxyde, la couche d'oxyde présentant une surface libre ;

b) implanter des espèces gazeuses dans le substrat donneur, à travers la couche d'oxyde, de manière à former une zone de fragilisation, les espèces gazeuses comprenant des atomes d'hydrogène ionisé ; la couche utile étant délimitée par la zone de fragilisation et par la première surface du substrat donneur ; la couche d'oxyde présente, à l'issue de l'étape b), un pic d'absorbance possédant un maximum à un premier nombre d'ondes, et possédant une largeur à mi-hauteur ;

c) appliquer un rayonnement ultraviolet à la surface libre de la couche d'oxyde, sous une atmosphère d'ozone, et selon un budget thermique adapté pour :

- décaler le maximum du pic d'absorbance d'au moins 3 cm$^{-1}$ vers les nombres d'onde croissants ;

- réduire la largeur à mi-hauteur d'au moins 3 cm$^{-1}$ ;

- autoriser une adhésion directe avec la surface libre de la couche d'oxyde ;

d) assembler le substrat donneur au substrat support par une adhésion directe avec la surface libre de la couche d'oxyde ;

e) fracturer le substrat donneur suivant la zone de fragilisation de manière à exposer la couche utile.

Ainsi, un tel procédé selon l'invention permet de corriger les modifications induites par l'étape b) d'implantation grâce au traitement UV-ozone de l'étape c) qui est exécuté avant l'étape d) de collage. Un tel traitement de l'étape c) permet de supprimer une partie des atomes d'hydrogène présents dans la couche d'oxyde, ce qui permet de réduire les défauts susceptibles d'apparaître à l'interface de collage. Le budget thermique appliqué lors de l'étape c) permet :

(i) d'éviter une dégradation des matériaux de la couche d'oxyde et du substrat donneur ;
(ii) d'avoir une contribution sur le budget thermique de fracture suffisamment faible pour ne pas fragiliser excessivement la zone de fragilisation avant l'étape d) de collage (e.g. bullage, exfoliation), et pour ne pas induire de déformation de surface rendant la surface libre de la couche d'oxyde incompatible avec une adhésion directe subséquente.

En outre, les inventeurs ont constaté, par spectroscopie infrarouge à transformée de Fourier de type réflectance totale atténuée (FTIR-ATR pour « *Fourier Transform InfraRed-Attenuated Total Reflectance* » en langue anglaise), qu'une telle modification du pic d'absorbance permet de caractériser l'efficacité du traitement de l'étape c) concernant la réduction des effets de l'endommagement de la couche d'oxyde liée à l'étape b) d'implantation. Cette réduction des effets de l'endommagement est liée en particulier à une suppression d'atomes d'hydrogène présents dans la couche d'oxyde.

### Définitions

- Par «couche utile », on entend une couche à partir de laquelle peut être formé un dispositif pour tout type d'applications, notamment électronique, mécanique, optique etc.
- Par « adhésion directe », on entend un collage spontané issu de la mise en contact direct de deux surfaces, c'est-à-dire en l'absence d'un élément additionnel tel qu'une colle, une cire ou une brasure. L'adhésion provient principalement des forces de van der Waals issues de l'interaction électronique entre les atomes ou les molécules de deux surfaces, des liaisons hydrogène du fait des préparations des surfaces ou des liaisons covalentes établies entre les deux surfaces. On parle également de collage par adhésion moléculaire.

Par « budget thermique », on entend le choix d'une valeur de température et d'une valeur de durée du traitement thermique.
Par « budget thermique de fracture », on entend le budget thermique total à appliquer après l'étape b) pour obtenir la fracture à l'issue de l'étape e). On peut définir un pourcentage du budget thermique de fracture. Le budget thermique de fracture peut être décrit par une loi de type Arrhenius permettant de relier le temps de la fracture (noté t) à la température du traitement thermique (notée T, en K) :

$$ t = A \, exp\left( {-E_a}/{kT} \right) $$

où :

- A est une constante,
- $E_a$ est une constante correspondant à l'énergie d'activation du mécanisme impliqué dans le transfert,
- k est la constante de Boltzmann.

$E_a$ peut être déterminée expérimentalement à partir de 2 points de fonctionnement : il s'agit de la pente de la droite log(t) en fonction de 1/kT.
$E_a$ étant connue, on détermine facilement pour une température $T_1$ donnée, le temps $t_1$ nécessaire à l'obtention de la fracture. Par convention, on dira que le pourcentage du budget thermique utilisé correspond au pourcentage du temps $t_1$ passé à la température $T_1$. Ainsi, par exemple, pour rester à moins de 10% du budget thermique de fracture, on choisira une durée t inférieure à $t_1/10$ pour un traitement thermique à une température $T_1$.
Le procédé selon l'invention peut comporter une ou plusieurs des caractéristiques suivantes.
Selon une caractéristique de l'invention, le budget thermique de l'étape c) est adapté pour décaler le maximum du pic d'absorbance d'au moins 5 cm$^{-1}$ vers les nombres d'onde croissants, de préférence d'au moins 10 cm$^{-1}$ vers les nombres d'onde croissants.
Selon une caractéristique de l'invention, la fracture de l'étape e) nécessite un budget thermique total ; et l'étape c) est exécutée selon un budget thermique inférieur ou égal à 10% du budget thermique total.
Ainsi, un avantage procuré est de ne pas fragiliser excessivement la zone de fragilisation avant l'étape d) de collage (e.g. bullage, exfoliation).
Selon une caractéristique de l'invention, la couche utile est réalisée en silicium ; et l'étape c) est exécutée pendant une durée choisie comprise entre 5 minutes et 6 heures, préférentiellement comprise entre 5 minutes et 2 heures, plus préférentiellement comprise entre 5 minutes et 1 heure.
Selon une caractéristique de l'invention, la couche utile est réalisée en silicium ; et la température du budget thermique de l'étape c) est comprise entre 250°C et 500°C, préférentiellement comprise entre 250°C et 500°C, plus préférentiellement comprise entre 290°C et 400°C.
Selon une caractéristique de l'invention, le procédé comporte une étape $d_1$) consistant à appliquer un traitement thermique à l'assemblage obtenu lors de l'étape d) selon un budget thermique adapté pour renforcer l'adhésion directe sans initier la fracture du substrat donneur suivant la zone de fragilisation ; l'étape d₁) étant exécutée avant l'étape e).

Ainsi, un avantage procuré est un renforcement de l'adhésion directe en termes d'adhérence permettant de réduire la taille de défauts susceptibles d'apparaître à l'interface de collage.

Selon une caractéristique de l'invention, la couche d'oxyde présente une épaisseur comprise entre 0,2 nm et 50 nm, préférentiellement comprise entre 1 nm et 15 nm, plus préférentiellement comprise entre 2 nm et 10 nm.

Ainsi, un avantage procuré est l'obtention d'un oxyde enterré (BOX pour « *Burried OXide* » en langue anglaise) très fin dans le cas de la fabrication d'un substrat de type SOI.

Selon une caractéristique de l'invention, la couche d'oxyde comprend au moins un matériau sélectionné parmi les groupes suivants :

- un oxyde diélectrique, préférentiellement $SiO_x$, $SrTiO_3$, $Al_2O_x$, $Y_2O_3$, $LaAlO_3$, $LiNbO_3$, $LiTaO_3$ ;
- un oxyde conducteur, préférentiellement $La_{0,5}Sr_{0,5}CoO_3$, $YBa_2Cu_3O_{7-x}$, $SrRuO_3$, $LaNiO_3$ ;
- un oxyde transparent conducteur, préférentiellement ZnO, ZnO :In, ZnO :Al, ZnO :F, ZnO :B, ZnO :Ga, $Zn_2SnO_1$, $GaInO_3$ :Ge, $GaInO_3$ :Sn, $MgIn_2O_1$, $ZnGa_2O_1$, $CuGaO_2$ :Fe.

Ainsi, un avantage procuré est l'obtention potentielle :

- d'un BOX lorsque le matériau de la couche d'oxyde est un oxyde diélectrique ;
- d'une électrode lorsque le matériau de la couche d'oxyde est électriquement conducteur (éventuellement transparent).

Selon une caractéristique de l'invention, le substrat donneur est réalisé dans un matériau sélectionné parmi les groupes suivants :

- un matériau semi-conducteur, préférentiellement Si, Ge, Si-Ge, un matériau III-V, $Si_{1-x-y}Ge_xSn_y$ ;
- un matériau piézoélectrique, préférentiellement $LiNbO_3$, $LiTaO_3$, $Pb(Zr_x,Ti_{1-x})O_3$.

Par « matériau III-V », on entend un alliage binaire entre des éléments situés respectivement dans la colonne III et dans la colonne V du tableau périodique des éléments.

Selon une caractéristique de l'invention, le procédé comporte une étape consistant à former une couche d'oxyde additionnelle sur le substrat support, l'étape d) étant exécutée de sorte que l'adhésion directe s'opère avec la couche d'oxyde additionnelle.

## Brève description des dessins

D'autres caractéristiques et avantages apparaîtront dans l'exposé détaillé de différents modes de réalisation de l'invention, l'exposé étant assorti d'exemples et de références aux dessins joints.

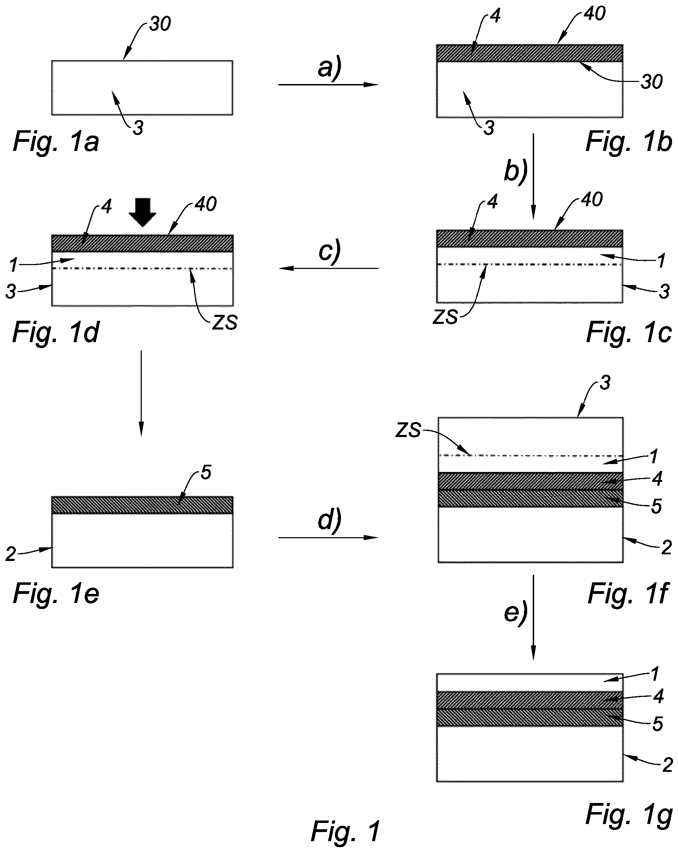

Figures 1a à 1g sont des vues schématiques en coupe illustrant un mode de mise en œuvre d'un procédé selon l'invention. Figures 1a à 1g ne sont pas représentées à l'échelle pour en simplifier leur compréhension.

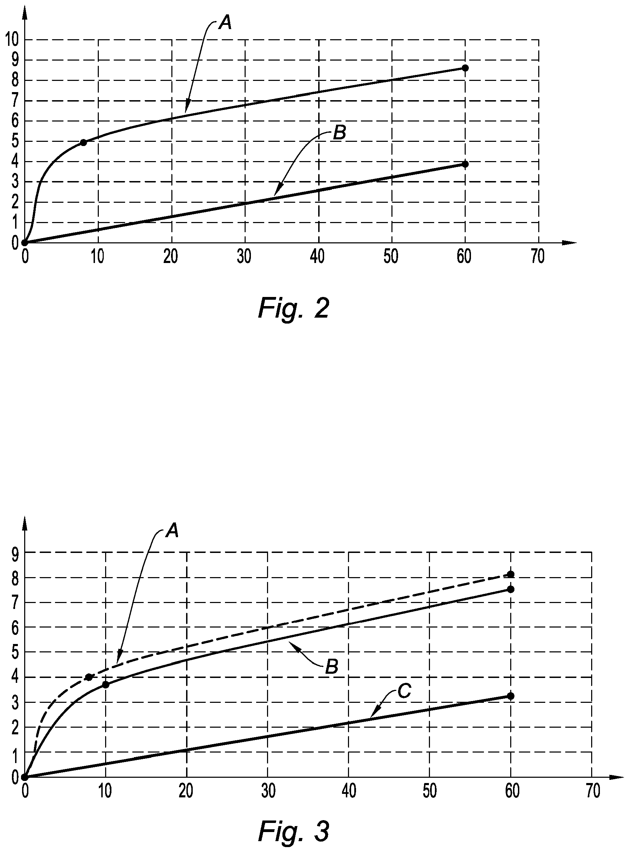

Figure 2 est un graphique représentant en abscisses la durée (en minutes) du traitement UV-ozone exécuté à 300°C, et en ordonnées la diminution de la largeur à mi-hauteur (en $cm^{-1}$) du pic d'absorbance (obtenu par spectroscopie FTIR-ATR sur la gamme [1100-1300] $cm^{-1}$) de la couche d'oxyde traitée ($SiO_x$). La courbe A correspond à une épaisseur de $SiO_x$ de 3 nm avec une énergie d'implantation de 65 keV. La courbe B correspond à une épaisseur de $SiO_x$ de 10 nm avec une énergie d'implantation de 76 keV.

Figure 3 est un graphique représentant en abscisses la durée (en minutes) du traitement UV-ozone exécuté à 300°C, et en ordonnées la variation du nombre d'onde (en $cm^{-1}$) du maximum du pic d'absorbance (obtenu par spectroscopie FTIR-ATR sur la gamme [1100-1300] $cm^{-1}$) de la couche d'oxyde traitée ($SiO_x$). La courbe A correspond à une épaisseur de $SiO_x$ de 3 nm avec une énergie d'implantation de 65 keV. La courbe B correspond à une épaisseur de $SiO_x$ de 10 nm avec une énergie d'implantation de 65 keV. La courbe C correspond à une épaisseur de $SiO_x$ de 10 nm avec une énergie d'implantation de 76 keV.

## Exposé détaillé des modes de réalisation

Les éléments identiques ou assurant la même fonction porteront les mêmes références pour les différents modes de réalisation, par souci de simplification.

Un objet de l'invention est un procédé de transfert d'une couche utile 1 sur un substrat support 2, comportant les étapes successives :

a) prévoir un substrat donneur 3 comprenant une première surface 30 recouverte d'une couche d'oxyde 4, la couche d'oxyde 4 présentant une surface libre 40 ;
b) implanter des espèces gazeuses dans le substrat donneur 3, à travers la couche d'oxyde 4, de manière à former une zone de fragilisation ZS, les espèces gazeuses comprenant des atomes d'hydrogène ionisé ; la couche utile 1 étant délimitée par la zone de fragilisation ZS et par la première surface 30 du substrat donneur 3 ; la couche d'oxyde 4 présente, à l'issue de l'étape b), un pic d'absorbance possédant un maximum à un premier nombre d'ondes, et possédant une largeur à mi-hauteur ;

c) appliquer un rayonnement ultraviolet à la surface libre 40 de la couche d'oxyde 4, sous une atmosphère d'ozone, et selon un budget thermique adapté pour :

- décaler le maximum du pic d'absorbance d'au moins 3 cm$^{-1}$ vers les nombres d'onde croissants ;
- réduire la largeur à mi-hauteur d'au moins 3 cm$^{-1}$ ;
- autoriser une adhésion directe avec la surface libre 40 de la couche d'oxyde 4 ;

d) assembler le substrat donneur 3 au substrat support 2 par une adhésion directe avec la surface libre 40 de la couche d'oxyde 4 ;

e) fracturer le substrat donneur 2 suivant la zone de fragilisation ZS de manière à exposer la couche utile 1.

L'étape a) est illustrée aux figures la et 1b. L'étape b) est illustrée à la figure 1c. L'étape c) est illustrée à la figure 1d. L'étape d) est illustrée à la figure 1f. Enfin, l'étape e) est illustrée à la figure 1g.

## Substrat donneur

Le substrat donneur 3 est réalisé dans un matériau sélectionné avantageusement parmi les groupes suivants :

- un matériau semi-conducteur, préférentiellement Si, Ge, Si-Ge, un matériau III-V, $Si_{1-x-y}Ge_xSn_y$ ;
- un matériau piézoélectrique, préférentiellement $LiNbO_3$, $LiTaO_3$, $Pb(Zr_x,Ti_{1-x})O_3$.

Il est à noter que d'autres matériaux sont envisageables pour le substrat donneur 3, tels que SiC, le quartz, le saphir ($Al_2O_3$).

## Couche d'oxyde

A titre d'exemple, la couche d'oxyde 4 peut être formée sur la première surface 30 du substrat donneur 3 par oxydation thermique, à 950°C, lorsque le substrat donneur 3 est en silicium, et lorsque la couche d'oxyde 4 est un oxyde de silicium $SiO_x$.

La couche d'oxyde 4 présente avantageusement une épaisseur comprise entre 0,2 nm et 50 nm, préférentiellement comprise entre 1 nm et 15 nm, plus préférentiellement comprise entre 2 nm et 10 nm. Toutefois, la couche d'oxyde 4 peut présenter une épaisseur supérieure à 50 nm, par exemple jusqu'à un micron. Dans ce cas, seule la partie superficielle de la couche d'oxyde 4 (typiquement les 10 nm, 20 nm voire 50 nm sous la surface libre 40) sera altérée par l'implantation de l'étape b) et modifiée par le traitement UV-ozone de l'étape c).

La couche d'oxyde 4 comprend avantageusement au moins un matériau sélectionné parmi les groupes suivants :

- un oxyde diélectrique, préférentiellement $SiO_x$, $SrTiO_3$, $Al_2O_x$, $Y_2O_3$, $LaAlO_3$, $LiNbO_3$, $LiTaO_3$ ;
- un oxyde conducteur, préférentiellement $La_{0,5}Sr_{0,5}CoO_3$, $YBa_2Cu_3O_{7-x}$, $SrRuO_3$, $LaNiO_3$ ;
- un oxyde transparent conducteur, préférentiellement ZnO, ZnO :In, ZnO :Al, ZnO :F, ZnO :B, ZnO :Ga, $Zn_2SnO_4$, $GaInO_3$ :Ge, $GaInO_3$ :Sn, $MgIn_2O_4$, $ZnGa_2O_4$, $CuGaO_2$ :Fe.

La couche d'oxyde 4 peut être une couche réalisée dans un matériau choisi parmi les matériaux précédents. La couche d'oxyde 4 peut être un empilement de sous-couches réalisées dans des matériaux différents choisis parmi les matériaux précédents. La couche d'oxyde 4 peut comporter une partie superficielle (au voisinage de la surface libre 40) réalisée dans un matériau choisi parmi les matériaux précédents.

## Substrat support

Comme illustré à la figure le, le procédé peut comporter une étape consistant à former une couche d'oxyde additionnelle 5 sur le substrat support 2, l'étape d) étant alors exécutée de sorte que l'adhésion directe s'opère avec la couche d'oxyde additionnelle 5.

La couche d'oxyde additionnelle 5 est préférentiellement réalisée dans le même matériau que celui de la couche d'oxyde 4, ou dans le même matériau que celui en surface de la couche d'oxyde 4.

## Etape b) d'implantation

Il est possible d'effectuer lors de l'étape b) une co-implantation avec d'autres espèces gazeuses (e.g. l'hélium), ou encore d'effectuer des implantations multiples des mêmes espèces gazeuses.

A titre d'exemple non limitatif, lorsque le substrat donneur 3 est réalisé en silicium, l'étape b) peut être exécutée avec des atomes d'hydrogène ionisé selon les paramètres suivants :

- une énergie comprise entre 65 keV et 85 keV,
- une dose de $5 \times 10^{16}$ at.cm$^{-2}$.

La couche d'oxyde 4 présente, à l'issue de l'étape b), un pic d'absorbance possédant un maximum à un premier nombre d'ondes, noté $\sigma_1$, et possédant une largeur à mi-hauteur (notée $L_1$).

## Etape c) de traitement UV-ozone

L'étape c) est exécutée selon un budget thermique adapté pour :

- décaler le maximum du pic d'absorbance à un deuxième nombre d'ondes, noté $\sigma_2$, vérifiant $\sigma_2 \geq \sigma_1 + 3$ cm$^{-1}$ ;
- réduire la largeur à mi-hauteur d'au moins 3 cm$^{-1}$ ;
- autoriser une adhésion directe avec la surface libre 40 de la couche d'oxyde 4.

En d'autres termes, le budget thermique de l'étape c) est supérieur à un premier budget thermique (noté BT1), au-dessus duquel :

- le maximum du pic d'absorbance est décalé à un deuxième nombre d'ondes, noté $\sigma_2$, vérifiant $\sigma_2 \geq \sigma_1 + 3$ cm$^{-1}$ ;
- la largeur à mi-hauteur est réduite d'au moins 3 cm$^{-1}$ par rapport à $L_1$.

Le budget thermique de l'étape c) est inférieur à un deuxième budget thermique (noté BT2), au-dessus duquel la déformation de la surface libre 40 de la couche d'oxyde 4 la rend incompatible avec une adhésion directe subséquente.

Autrement dit, le budget thermique appliqué lors de l'étape c) est compris entre BT1 et BT2.

Le budget thermique de l'étape c) est avantageusement adapté pour décaler le maximum du pic d'absorbance à un deuxième nombre d'ondes vérifiant $\sigma_2 \geq \sigma_1 + 5$ cm$^{-1}$, de préférence $\sigma_2 \geq \sigma_1 + 10$ cm$^{-1}$. En d'autres termes, le budget thermique de l'étape c) est avantageusement adapté pour décaler le maximum du pic d'absorbance d'au moins 5 cm$^{-1}$ vers les nombres d'onde croissants, de préférence d'au moins 10 cm$^{-1}$ vers les nombres d'onde croissants.

Lorsque le substrat donneur 3 est en silicium, et lorsque la couche d'oxyde 4 est un oxyde de silicium $SiO_x$. la modification du pic d'absorbance peut être observée par FTIR-ATR sur la gamme [1100-1300] cm$^{-1}$, englobant les modes optiques longitudinaux (LO) et les modes optiques transversaux (TO) des vibrations des liaisons Si-O-Si. Les spectres infrarouges obtenus par FTIR-ATR sont avantageusement normalisés par rapport à la valeur maximale du spectre de référence, c'est-à-dire le spectre d'une couche d'oxyde 4 de référence non soumise à l'étape b) d'implantation. Il est possible de relier la position du maximum du pic d'absorbance à la stœchiométrie et au stress de l'oxyde de silicium $SiO_x$, tandis que la largeur à mi-hauteur du pic d'absorbance est reliée à l'endommagement structurel de l'oxyde de silicium $SiO_x$. Ainsi, les inventeurs ont constaté que l'étape b) d'implantation conduit à :

- un décalage du maximum du pic d'absorbance vers les nombres d'onde décroissants par rapport au spectre de référence,
- un élargissement de la largeur à mi-hauteur du pic d'absorbance ;

Puis, les inventeurs ont constaté qu'un traitement UV-ozone exécuté selon un budget thermique adapté permet de :

- décaler le maximum du pic d'absorbance vers les nombres d'onde croissants,
- réduire la largeur à mi-hauteur du pic d'absorbance ;

ce qui traduit une réduction des effets de l'endommagement de la couche d'oxyde 4 provoqué par l'étape b) d'implantation.

En d'autres termes, le budget thermique de l'étape c) peut être choisi selon le niveau de réduction souhaité des effets de l'endommagement de la couche d'oxyde 4. A titre d'exemple, lorsque la couche d'oxyde 4 est $SiO_x$, avec une épaisseur de 3 nm, la courbe A de la figure 2 montre qu'un traitement UV-ozone de 60 minutes à 300°C permet de diminuer la largeur à mi-hauteur du pic d'absorbance d'une valeur de 8,6 cm$^{-1}$, ce qui correspond à une réduction d'environ 30% des effets de l'endommagement de la couche d'oxyde 4 liée à l'étape b) d'implantation. Pour un niveau de réduction plus élevé, à température constante, il est nécessaire d'effectuer un traitement UV-ozone de plusieurs heures.

De la même façon, à titre d'exemple, lorsque la couche d'oxyde 4 est $SiO_x$, avec une épaisseur de 3 nm, la courbe A de la figure 3 montre qu'un traitement UV-ozone de 60 minutes à 300°C permet de décaler le maximum du pic d'absorbance vers les nombres d'onde croissants d'une valeur de 8 cm$^{-1}$, ce qui correspond à une réduction d'environ 70% des effets de l'endommagement de la couche d'oxyde 4 liée à l'étape b) d'implantation. Pour un niveau de réduction plus élevé, à température constante, il est nécessaire d'effectuer un traitement UV-ozone de plusieurs heures.

La fracture de l'étape e) nécessite un budget thermique total. L'étape c) est avantageusement exécutée selon un budget thermique inférieur ou égal à 10% du budget thermique total. Au-delà d'un certain budget thermique, des défauts apparaissent en surface (e.g. bullage, cloquage) et rendent impossible l'étape d) de collage direct.

Lorsque la couche utile 1 est réalisée en silicium, par exemple lorsque le substrat donneur 3 est réalisée en silicium et la couche d'oxyde 4 est $SiO_x$, l'étape c) est avantageusement exécutée pendant une durée choisie comprise entre 5 minutes et 6 heures, préférentiellement comprise entre 5 minutes et 2 heures, plus préférentiellement comprise entre 5 minutes et 1 heure.

La température du budget thermique de l'étape c) est préférentiellement strictement supérieure à la température ambiante, plus préférentiellement supérieure ou égale à 50°C, encore plus préférentiellement supérieure ou égale à 100°C. Lorsque la couche utile 1 est réalisée en silicium, par exemple lorsque le substrat donneur 3 est réalisée en silicium et la couche d'oxyde 4 est $SiO_x$, la température du budget thermique de l'étape c) est avantageusement comprise entre 250°C et 500°C, préférentiellement comprise entre 250°C et 450°C, plus préférentiellement comprise entre 290°C et 400°C.

L'étape c) peut être précédée d'une étape consistant à nettoyer la surface libre 40 de la couche d'oxyde 4 afin d'améliorer son caractère hydrophile en vue de l'étape d) de collage.

### Etape d) de collage

A titre d'exemple non limitatif, l'étape d) peut être exécutée sous vide poussé tel qu'un vide secondaire inférieur à $10^{-2}$ mbar, ou encore sous atmosphère contrôlée de salle blanche.

### Etape e) de fracture

L'étape e) de fracture (« *splitting* » en langue anglaise) est avantageusement exécutée par un traitement thermique selon un budget thermique adapté.

### Renforcement de l'interface de collage

Le procédé comporte avantageusement une étape $d_1$) consistant à appliquer un traitement thermique à l'assemblage obtenu lors de l'étape d) selon un budget thermique adapté pour renforcer l'adhésion directe sans initier la fracture du substrat donneur 3 suivant la zone de fragilisation ZS ; l'étape $d_1$) étant exécutée avant l'étape e).

Le budget thermique de l'étape $d_1$) est avantageusement choisi afin de ne pas dépasser 10% du budget thermique de fracture. A titre d'exemple non limitatif, la température du budget thermique de $d_1$) peut être de l'ordre de 300°C pour une durée de l'ordre d'une heure.

Le procédé comporte avantageusement des étapes antérieures à l'étape d), consistant à nettoyer et préparer les surfaces à coller. A titre d'exemples non limitatifs, ces étapes antérieures à l'étape d) peuvent être exécutées par un traitement plasma ou par pulvérisation par faisceau d'ions (IBS pour « *Ion Beam Sputtering* » en langue anglaise). Ces étapes antérieures à l'étape d) peuvent nécessiter l'application d'un budget thermique qui doit rester suffisamment faible pour ne pas initier la fracture du substrat donneur 3 suivant la zone de fragilisation ZS, et ne pas déformer la surface libre 40 de la couche d'oxyde 4 (la rendant incompatible avec le collage direct subséquent). On se limitera à un budget thermique inférieur à 10% du budget thermique de fracture.

Le procédé comporte avantageusement une étape f) consistant à appliquer un traitement thermique à l'assemblage obtenu à l'issue de l'étape e), selon un budget thermique adapté pour renforcer l'adhésion directe entre la couche utile 1 et le substrat support 2.

L'invention ne se limite pas aux modes de réalisation exposés. L'homme du métier est mis à même de considérer leurs combinaisons techniquement opérantes, et de leur substituer des équivalents. La portée de l'invention est uniquement définie par les revendications annexés.

## Revendications

1. Procédé de transfert d'une couche utile (1) sur un substrat support (2), comportant les étapes successives :

   a) prévoir un substrat donneur (3) comprenant une première surface (30) recouverte d'une couche d'oxyde (4), la couche d'oxyde (4) présentant une surface libre (40) ;
   b) implanter des espèces gazeuses dans le substrat donneur (3), à travers la couche d'oxyde (4), de manière à former une zone de fragilisation (ZS), les espèces gazeuses comprenant des atomes d'hydrogène ionisé ; la couche utile (1) étant délimitée par la zone de fragilisation (ZS) et par la première surface (30) du substrat donneur (3) ; la couche d'oxyde (4) présente, à l'issue de l'étape b), un pic d'absorbance possédant un maximum à un premier nombre d'ondes, et possédant une largeur à mi-hauteur ;
   c) appliquer un rayonnement ultraviolet à la surface libre (40) de la couche d'oxyde (4), sous une atmosphère d'ozone, et selon un budget thermique supérieur à un premier budget thermique au-dessus duquel :

      - le maximum du pic d'absorbance est décalé d'au moins 3 $cm^{-1}$ vers les nombres d'onde croissants ;
      - la largeur à mi-hauteur est réduite d'au moins 3 $cm^{-1}$ ;
      le budget thermique de l'étape c) étant inférieur à un second budget thermique en-deçà duquel une adhésion directe avec la surface libre (40) de la couche d'oxyde (4) est autorisée ;

   d) assembler le substrat donneur (3) au substrat support (2) par une adhésion directe avec la surface libre (40) de la couche d'oxyde (4) ;
   e) fracturer le substrat donneur (3) suivant la zone de fragilisation (ZS) de manière à exposer la couche utile (1).

2. Procédé selon la revendication 1, dans lequel le budget thermique de l'étape c) est adapté pour décaler le maximum du pic d'absorbance d'au moins 5 $cm^{-1}$ vers les nombres d'onde croissants, de préférence d'au moins 10 $cm^{-1}$ vers les nombres d'onde croissants.

3. Procédé selon la revendication 1 ou 2, dans lequel la fracture de l'étape e) nécessite un budget thermique total ; et l'étape c) est exécutée selon un budget thermique inférieur ou égal à 10% du budget thermique total.

EP 3 503 173 B1

**4.** Procédé selon l'une des revendications 1 à 3, dans lequel la couche utile (1) est réalisée en silicium ; et dans lequel l'étape c) est exécutée pendant une durée choisie comprise entre 5 minutes et 6 heures, préférentiellement comprise entre 5 minutes et 2 heures, plus préférentiellement comprise entre 5 minutes et 1 heure.

**5.** Procédé selon l'une des revendications 1 à 4, dans lequel la couche utile (1) est réalisée en silicium ; et dans lequel la température du budget thermique de l'étape c) est comprise entre 250°C et 500°C, préférentiellement comprise entre 250°C et 450°C, plus préférentiellement comprise entre 290°C et 400°C.

**6.** Procédé selon l'une des revendications 1 à 5, comportant une étape $d_1$) consistant à appliquer un traitement thermique à l'assemblage obtenu lors de l'étape d) selon un budget thermique adapté pour renforcer l'adhésion directe sans initier la fracture du substrat donneur (3) suivant la zone de fragilisation (ZS) ; l'étape $d_1$) étant exécutée avant l'étape e).

**7.** Procédé selon l'une des revendications 1 à 6, dans lequel la couche d'oxyde (4) présente une épaisseur comprise entre 0,2 nm et 50 nm, préférentiellement comprise entre 1 nm et 15 nm, plus préférentiellement comprise entre 2 nm et 10 nm.

**8.** Procédé selon l'une des revendications 1 à 7, dans lequel la couche d'oxyde (4) comprend au moins un matériau sélectionné parmi les groupes suivants :

- un oxyde diélectrique, préférentiellement $SiO_x$, $SrTiO_3$, $Al_2O_x$, $Y_2O_3$, $LaAlO_3$, $LiNbO_3$, $LiTaO_3$ ;
- un oxyde conducteur, préférentiellement $La_{0,5}Sr_{0,5}CoO_3$, $YBa_2Cu_3O_{7-x}$, $SrRuO_3$, $LaNiO_3$ ;
- un oxyde transparent conducteur, préférentiellement ZnO, ZnO :In, ZnO :Al, ZnO :F, ZnO :B, ZnO :Ga, $Zn_2SnO_1$ $GaInO_3$ :Ge, $GaInO_3$ :Sn, $MgIn_2O_1$, $ZnGa_2O_1$ $CuGaO_2$ :Fe.

**9.** Procédé selon l'une des revendications 1 à 8, dans lequel le substrat donneur (3) est réalisé dans un matériau sélectionné parmi les groupes suivants :

- un matériau semi-conducteur, préférentiellement Si, Ge, Si-Ge, un matériau III-V, $Si_{1-x-y}Ge_xSn_y$ ;
- un matériau piézoélectrique, préférentiellement $LiNbO_3$, $LiTaO_3$, $Pb(Zr_x,Ti_{1-x})O_3$.

**10.** Procédé selon l'une des revendications 1 à 9, comportant une étape consistant à former une couche d'oxyde additionnelle (5) sur le substrat support (2), l'étape d) étant exécutée de sorte que l'adhésion directe s'opère avec la couche d'oxyde additionnelle (5).

**Patentansprüche**

**1.** Verfahren zur Übertragung einer Nutzschicht (1) auf ein Trägersubstrat (2), umfassend die aufeinanderfolgenden Schritte:

a) Bereitstellen eines Spendersubstrats (3), das eine erste Fläche (30) umfasst, die mit einer Oxidschicht (4) bedeckt ist, wobei die Oxidschicht (4) eine freie Oberfläche (40) aufweist;
b) Einbringen von gasförmigen Spezies in das Spendersubstrat (3) durch die Oxidschicht (4) hindurch derart, dass eine Schwächungszone (ZS) gebildet wird, wobei die gasförmigen Spezies ionisierte Wasserstoffatome umfassen; wobei die Nutzschicht (1) durch die Schwächungszone (ZS) und die erste Fläche (30) des Spendersubstrats (3) begrenzt ist; wobei die Oxidschicht (4) am Ende von Schritt b) einen Absorbanzpeak aufweist, der ein Maximum bei einer ersten Wellenzahl besitzt und eine Halbwertsbreite besitzt;
c) Bestrahlen der freien Oberfläche (40) der Oxidschicht (4) mit ultravioletter Strahlung unter einer Ozonatmosphäre und entsprechend einem Wärmehaushalt, der über einem ersten Wärmehaushalt liegt, oberhalb dessen:

- das Maximum des Absorbanzpeaks um mindestens 3 cm$^{-1}$ in Richtung größer werdender Wellenzahlen verschoben wird;
- die Halbwertsbreite um mindestens 3 cm$^{-1}$ reduziert wird;
wobei der Wärmehaushalt von Schritt c) geringer ist als ein zweiter Wärmehaushalt, unter dem eine unmittelbare Haftung an der freien Oberfläche (40) der Oxidschicht (4) zulässig ist;

d) Anfügen des Spendersubstrats (3) am Trägersubstrat (2) über eine unmittelbare Haftung an der freien Oberfläche (40) der Oxidschicht (4);
e) Abtrennen des Spendersubstrats (3) entlang der Schwächungszone (ZS) derart, dass die Nutzschicht (1) freigelegt wird.

**2.** Verfahren nach Anspruch 1, wobei der Wärmehaushalt von Schritt c) so angepasst wird, dass das Maximum des Absorbanzpeaks um mindestens 5 cm$^{-1}$ in Richtung größer werdender Wellenzahlen, vorzugsweise um mindestens 10 cm$^{-1}$ in Richtung größer werdender Wellenzahlen verschoben wird.

**3.** Verfahren nach Anspruch 1 oder 2, wobei für die Abtrennung in Schritt e) ein Gesamtwärmehaushalt notwendig ist und Schritt c) mit einem Wärmehaushalt von kleiner gleich 10% des Gesamtwärmehaushalts durchgeführt wird.

4. Verfahren nach einem der Ansprüche 1 bis 3, wobei die Nutzschicht (1) aus Silicium gefertigt ist, und wobei Schritt c) während eines gewählten Zeitraums zwischen 5 Minuten und 6 Stunden, vorzugsweise zwischen 5 Minuten und 2 Stunden, bevorzugter zwischen 5 Minuten und 1 Stunde durchgeführt wird.

5. Verfahren nach einem der Ansprüche 1 bis 4, wobei die Nutzschicht (1) aus Silicium gefertigt ist, und wobei die Temperatur des Wärmehaushalts von Schritt c) zwischen 250°C und 500°C, vorzugsweise zwischen 250°C und 450°C, bevorzugter zwischen 290°C und 400°C liegt.

6. Verfahren nach einem der Ansprüche 1 bis 5, das einen Schritt $d_1$) umfasst, der darin besteht, an der Anordnung, die in Schritt d) erhalten wird, eine Wärmebehandlung bei einem Wärmehaushalt vorzunehmen, der so angepasst ist, dass die unmittelbare Haftung verstärkt wird, ohne dass die Abtrennung des Spendersubstrats (3) entlang der Schwächungszone (ZS) ausgelöst wird; wobei Schritt $d_1$) vor Schritt e) durchgeführt wird.

7. Verfahren nach einem der Schritte 1 bis 6, wobei die Oxidschicht (4) eine Dicke zwischen 0,2 nm und 50 nm, vorzugsweise zwischen 1 nm und 15 nm, bevorzugter zwischen 2 nm und 10 nm aufweist.

8. Verfahren nach einem der Ansprüche 1 bis 7, wobei die Oxidschicht (4) mindestens ein Material umfasst, das aus den folgenden Gruppen ausgewählt wird:

   - ein dielektrisches Oxid, vorzugsweise $SiO_s$, $SrTiO_3$, $Al_2O_x$, $Y_2O_3$, $LaAlO_3$, $LiNbO_3$, $LiTaO_3$;
   - ein leitfähiges Oxid, vorzugsweise $La_{0,5}Sr_{0,5}CoO_3$, $YBa_2Cu_3O_{7-x}$, $SrRuO_3$, $LaNiO_3$;
   - ein leitfähiges durchsichtiges Oxid, vorzugsweise ZnO, ZnO:In, ZnO:Al, ZnO:F, ZnO:B, ZnO:Ga, $Zn_2SnO_4$, $GaInO_3$:Ge, $GaInO_3$:Sn, $MgIn_2O_4$, $ZnGa_2O_4$, $CuGaO_2$:Fe.

9. Verfahren nach einem der Ansprüche 1 bis 8, wobei das Spendersubstrat (3) aus einem Material gefertigt ist, das aus den folgenden Gruppen ausgewählt wird:

   - ein Halbleitermaterial, vorzugsweise Si, Ge, Si-Ge, ein III-V-Material, $Si_{1-x-y}Ge_xSn_y$;
   - ein piezoelektrisches Material, vorzugsweise $LiNbO_3$, $LiTaO_3$, $Pb(Zr_xTi_{1-x})O_3$.

10. Verfahren nach einem der Ansprüche 1 bis 9, das einen Schritt umfasst, der im Bilden einer zusätzlichen Oxidschicht (5) auf dem Trägersubstrat (2) besteht, wobei Schritt d) derart durchgeführt wird, dass die unmittelbare Haftung an der zusätzlichen Oxidschicht (5) erfolgt.

## Claims

1. Method for transfer of a useful layer (1) onto a supporting substrate (2), comprising the successive steps of:

   a) providing a donor substrate (3) comprising a first surface (30) covered with a layer of oxide (4), the layer of oxide (4) having a free surface (40);
   b) implanting gaseous species in the donor substrate (3), through the layer of oxide (4), so as to form an embrittlement zone (ZS), the gaseous species comprising ionized hydrogen atoms; the useful layer (1) being delimited by the embrittlement zone (ZS) and by the first surface (30) of the donor substrate (3); at the end of step b), the layer of oxide (4) has an absorbance peak possessing a maximum at a first wavenumber, and possessing a full width at half maximum;
   c) applying ultraviolet radiation to the free surface (40) of the layer of oxide (4), under an ozone atmosphere, and according to a thermal budget greater than a first thermal budget, above which:

   - the maximum of the absorbance peak is shifted by at least 3 cm$^{-1}$ towards increasing wavenumbers;
   - the full width at half maximum is reduced by at least 3 cm$^{-1}$;
   the thermal budget in step c) being lower than a second thermal budget below which direct adhesion with the free surface (40) of the layer of oxide (4) is permitted;

   d) assembling the donor substrate (3) on the supporting substrate (2) by direct adhesion with the free surface (40) of the layer of oxide (4);
   e) splitting the donor substrate (3) along the embrittlement zone (ZS) so as to expose the useful layer (1).

2. Method according to Claim 1, wherein the thermal budget in step c) is suitable for shifting the maximum of the absorbance peak by at least 5 cm$^{-1}$ towards increasing wavenumbers, preferably by at least 10 cm$^{-1}$ towards increasing wavenumbers.

3. Method according to Claim 1 or 2, wherein the splitting in step e) requires a total thermal budget; and step c) is executed according to a thermal budget less than or equal to 10% of the total thermal budget.

4. Method according to one of Claims 1 to 3, wherein the useful layer (1) is made of silicon; and in which step c) is executed for a time selected between 5 minutes and 6 hours, preferably between 5 minutes and 2 hours, more preferably between 5 minutes and 1 hour.

5. Method according to one of Claims 1 to 4, wherein the useful layer (1) is made of silicon; and in which the temperature of the thermal budget in step c) is between 250°C and 500°C, preferably between 250°C and 450°C, more preferably between 290°C and 400°C.

6. Method according to one of Claims 1 to 5, comprising a step $d_1$) consisting of applying a thermal treatment to the assembly obtained in step d) according to a thermal budget suitable for reinforcing direct adhesion without initiating splitting of the donor substrate (3) along the embrittlement zone (ZS); step $d_1$) being executed before step e).

7. Method according to one of Claims 1 to 6, wherein the layer of oxide (4) has a thickness between 0.2 nm and 50 nm, preferably between 1 nm and 15 nm, more preferably between 2 nm and 10 nm.

8. Method according to one of Claims 1 to 7, wherein the layer of oxide (4) comprises at least one material selected from the following groups:

   - a dielectric oxide, preferably $SiO_x$, $SrTiO_3$, $Al_2O_x$, $Y_2O_3$, $LaAlO_3$, $LiNbO_3$, $LiTaO_3$;
   - a conductive oxide, preferably $La_{0.5}Sr_{0.5}CoO_3$, $YBa_2Cu_3O_{7-x}$, $SrRuO_3$, $LaNiO_3$;
   - a transparent conductive oxide, preferably ZnO, ZnO:In, ZnO:Al, ZnO:F, ZnO:B, ZnO:Ga, $Zn_2SnO_4$, $GaInO_3$:Ge, $GaInO_3$:Sn, $MgIn_2O_4$, $ZnGa_2O_4$, $CuGaO_2$:Fe.

9. Method according to one of Claims 1 to 8, wherein the donor substrate (3) is made of a material selected from the following groups:

   - a semiconductor material, preferably Si, Ge, Si-Ge, a III-V material, $Si_{1-x-y}Ge_xSn_y$;
   - a piezoelectric material, preferably $LiNbO_3$, $LiTaO_3$, $Pb(Zr_x,Ti_{1-x})O_3$.

10. Method according to one of Claims 1 to 9, comprising a step consisting of forming an additional layer of oxide (5) on the supporting substrate (2), step d) being executed in such a way that direct adhesion takes place with the additional layer of oxide (5).

*Fig. 1a*

*Fig. 1b*

*Fig. 1c*

*Fig. 1d*

*Fig. 1e*

*Fig. 1f*

*Fig. 1g*

*Fig. 1*

Fig. 2

Fig. 3

## RÉFÉRENCES CITÉES DANS LA DESCRIPTION

**Documents brevets cités dans la description**

- US 6403450 B1

**Littérature non-brevet citée dans la description**

- **LISOVSKI I.P. ; LITOVCHENKO V.G. ; LOZINSKII V.B.** Effect of UV annealing of radiation damage in SiO2 films. *Applied Surface Science,* 1995, vol. 86, 299-302